# EUROPEAN PATENT SPECIFICATION

(11) **EP 0 343 663 B1**
(45) Date of publication and mention of the grant of the patent: **30.11.1994**
(21) Application number: 89109444.3
(22) Date of filing: 24.05.1989
(51) Int. Cl.: H01H 1/02, H01H 33/66

(54) **Vacuum interrupter contacts and process for producing the same**
Vakuumschalterkontakte und Verfahren zur Herstellung derselben
Contacts d'un interrupteur à vide et méthode de fabrication

(30) Priority: 27.05.1988 JP 129640/88
(43) Date of publication of application: 29.11.1989
(73) Proprietor: KABUSHIKI KAISHA TOSHIBA, Kawasaki-shi, Kanagawa-ken 210 (JP)
(72) Inventor: Fujita, Hajime, Hachioji-Shi Tokyo-To (JP); Chiba, Seishi, Yokohama-Shi Kanagawa-Ken (JP); Okutomi, Tsutomu, Yokohama-Shi Kanagawa-Ken (JP); Suzuki, Kazuo, Tokyo-To (JP); Idehara, Masami, Fuchu-Shi Tokyo-To (JP); Honma, Mitsutaka, Tokorozawa-Shi Saitama-Ken (JP); Takashima, Seikichi, Yokohama-Shi (JP)
(74) Representative: Liesegang, Roland, Dr.-Ing.

(56) References cited:
- EP-A- 0 175 349
- DE-A- 2 848 980
- GB-A- 2 056 177
- PATENT ABSTRACTS OF JAPAN vol. 13, no. 196 (E-755)(3544) 10 May 1989 & JP-A-01 17344 (TOSHIBA) 20 January 1989

## Description

The invention relates to a vacuum breaker contact according to the preamble of claim 1 and to a method for producing a vacuum breaker contact according to the preamble of claim 10. A vacuum breaker contact of this type is known from the GB-A-2 056 177.

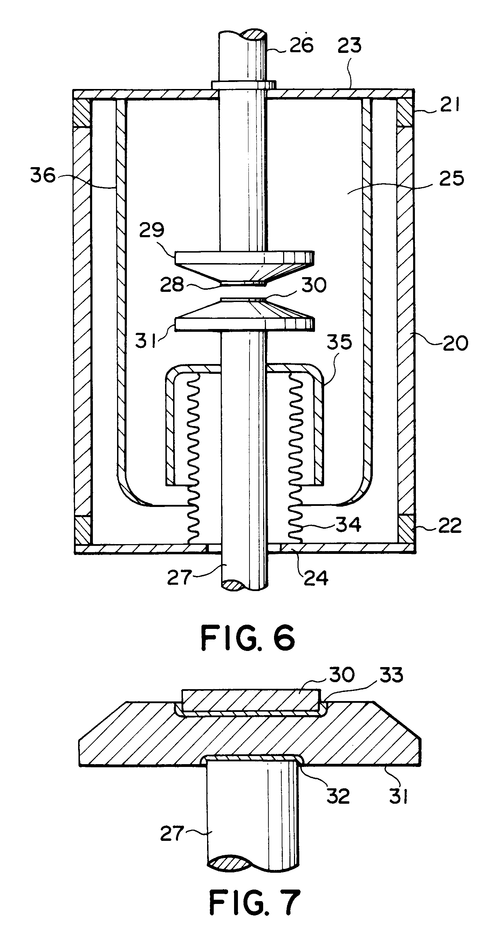

Fig. 6 shows a sectional view of a vacuum interrupter (also called as vacuum circuit breaker or vacuum valve). The vacuum interrupter has a substantially cylindrical insulating vessel 20, and a vacuum vessel constituted of end plates 23, 24 made of a metal mounted through sealing fitments 21, 22 at both end faces of the vessel 20. Internally of the vacuum vessel is formed a shielding chamber 25 of vacuum atmosphere.

Within the shielding chamber 25, there are arranged a first electroconductive rod 26 mounted fixedly extending through the end plate 23, and a second electroconductive rod 27 mounted movably in the axial direction extending through the end plate 24. At the respective opposed ends of these first and second electroconductive rods 26, 27 are mounted a movable electrode 29 having a contact 28 and a movable electrode 31 having a contact 30 so as to be opposed to each other.

Between the second electroconductive rod 27 and the end plate 24, there is mounted a bellows 34 for maintaining air tightness. Outside of the bellows is mounted a bellows cover 35 for protecting the bellows 34 from the arc vapor generated between the both contacts 28, 30. Further, internally of the vacuum vessel, there is provided an arc shield 36 for protecting the insulating vessel 20 from the arc vapor. The vacuum interrupter is adapted to be opened and closed according to a driving mechanism (not shown) through the above electroconductive rod 27.

Next, description is made by referring to Fig. 7. On the electroconductive rod 27, a movable electrode 31 is mounted through a soldering portion 32. On the movable electrode 31 is mounted a contact through the soldering portion 33. The contact, after worked into a predetermined shape, is assembled into the shielding chamber as such soldered onto the electrode or the electroconductive rod. If necessary, the conditioning treatment is applied to clean and finish the surface. Also, as similar materials for contact, alloys such as Cu-Bi type, Cu-Te type, Cu-W type, Cu-WC type, Cu-Cr type, Cu-Ti type, etc. have been used variously suitably depending on the purpose.

Whereas, it is demanded for this kind of vacuum interrupter contact that its surface should not be contaminated with oxide coating, etc. However, the material for contact has the problem that the surface oxidation proceeds in the course from working to assembling in vacuum interrupter. Besides, depending on the situation of management during that time, there are following problems in the aspect that the state of contamination is not constant and the quality is not stabilized.

First, such contamination cannot be removed easily even by the conditioning treatment, and therefore there is the problem that the contact resistance characteristics as a contact becomes unstable.

To cope with this problem, it has been practiced to attach a metal coating such as Cu onto the surface of the contact substrate, thereby alleviating influence from atmosphere. In case of this countermeasure, for stabilizing contact resistance, the metal coating is required to be formed sufficiently thick. However, if it is too thick, not only lowering in welding resistance as the contact is brought about, but also the adhesion strength between the coating and the contact substrate is weakened to give rise to peeling, whereby there is also a problem that lowering in dielectric strength characteristics may be brought about.

In the case where the cause for making the contact resistance higher resides in formation of an oxide coating of an active metal such as Al, Ti, Cr, etc., it may be considered to remove mechanically the oxide coating by blasting of rigid particles. However, in this case, the blasted rigid particles may be penetrated into the matrix to remain there, and also the surface roughening proceeeds, whereby there is the problem that no necessarily satisfactory value in aspect in dielectric strength characteristics can be obtained. Also, for thermally stable coating such as oxide of Al, Ti or Cr, time and expenses are consuming for carrying out reduction with hydrogen or voltage-current conditioning treatment to be inconvenient without obtaining sufficient effect in many cases.

The next problem is that, when the vacuum interrupter contact is generally solder bonded to an electrode in a hydrogen reducing atmosphere, nitrogen or vacuum atmosphere, the strength of the solder bonded portion is affected by contamination of the oxide coating of the vacuum interrupter contact, and depending on the state of such contamination, the strength at the solder bonded portion may become extremely weak. In the contact material containing an active metal such as Al, Ti or Cr, there is the problem that particularly formation of an oxide coating exerts an influence on the strength of the solder bonded portion.

The GB-A-2 056 177 describes a vacuum switch contact where a metal coating is formed by ion implantation using alloy materials, such as Cr, Fe, Ni etc. The penetration depth of the ions within the contact surface may vary between 0.1 and 10 micron.

The EP-A-0 175 349 discloses a vacuum circuit breaker where a metal film is formed on the electrode surface of the contact by evaporating Co, Ni, Cu or Ag etc.

### SUMMARY OF THE INVENTION

Accordingly, an object of the present invention is to cancel the problems possessed by the prior art as described above and provide a vacuum interrupter contact having great strength at the solder bonded portion and a process for producing the same.

According to the invention this object is solved by a vacuum breaker contact comprising the features of claim 1 and a method for producing a vacuum breaker contact comprising the features of claim 10, respectively.

### BRIEF DESCRIPTION OF THE DRAWINGS

In the drawings:
Fig. 1 is a longitudinal sectional view showing the state before the diffusion step of the vacuum interrupter contact of the present invention;
Fig. 2 is a longitudinal sectional view showing the state after the diffusion step of the vacuum interrupter contact of the present invention;
Fig. 3 and Fig. 4 are each longitudinal sectional view showing the vacuum interrupter contact of the present invention;
Fig. 5 is a longitudinal sectional view showing another example of the present invention;
Fig. 6 is a longitudinal sectional view showing the vacuum interrupter contact of the prior art; and
Fig. 7 is a longitudinal sectional view of the electrode portion of the vacuum interrupter shown in Fig. 6.

### DETAILED DESCRIPTION OF THE INVENTION

The surface of the vacuum interrupter contact is subjected to contamination from atmosphere. Even if the time from the contact working to the breaker assembling may be shortened, there is of itself a limit in prevention of contamination. According to the present invention, a metal coated layer is formed on the contact substrate, and yet at the interface between the contact substrate and the metal coated layer, the metal coated layer is adapted to be diffused to a predetermined thickness into the contact substrate. In this case, by making the metal coated layer at the undiffused portion existing on the contact substrate to 10 µm or less, the contact itself can be made excellent in welding characteristics. Moreover, even if it is subjected to mechanical or thermal impact during opening or closing of the contact or during shielding actuation, since the change is adapted to occur as associated with the change received by the contact, there will not occur peel-off because of the diffusion effect in the above diffusion region.

In the following, referring to the accompanying drawings, specific embodiments of the vacuum interrupter contact and the process for producing the same of the present invention are to be described.

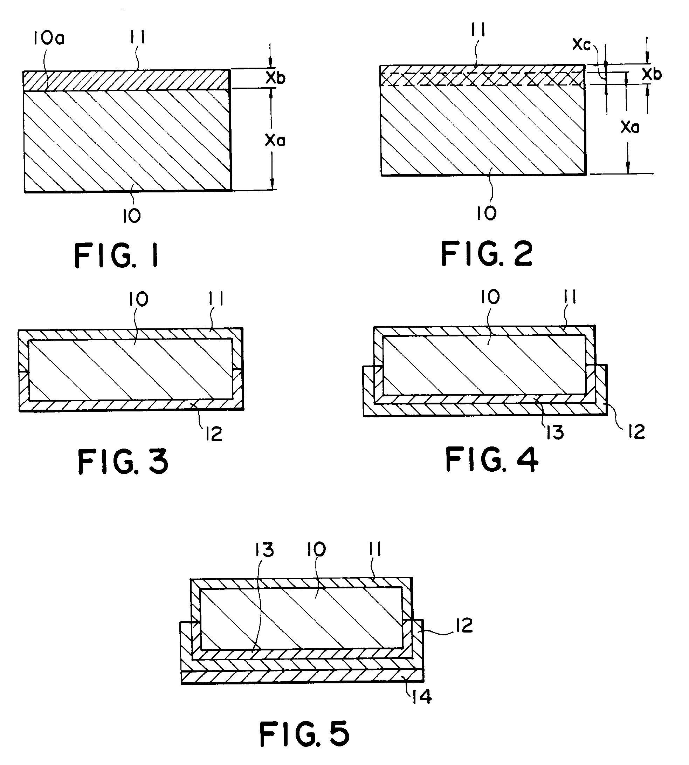

First, the step of forming a metal coated layer on the contact surface side of the contact substrate is to be described. The coating step, as shown in Fig. 1, prepares a contact substrate 10 having a thickness Xa, and forms a contact surface side metal coated layer 11 for contamination prevention having a thickness Xb on the contact surface 10a of the contact substrate 10 according to the ion plating method.

Here, as the contact substrate 10, for example, alloys of Cu-Bi type, Cu-Te type, Cu-W type, Cu-WC type, Ag-W type, AG-WC type, Cu-Cr type, Cu-Ti type, etc., may be used variously depending on the purpose. Also, as the contact surface side metal coated layer 11, at least one metal selected from among Cu, Ag, Ni, Sn, In and Fe or alloys of these can be used.

Next, in the diffusion step, as shown in Fig. 2, the contact surface side metal coating layer 11 formed is diffused on the contact surface 10a of the contact substrate 10. As the means to be used for such diffusion, there are means such as (1) diffusion as a separate step after completion of the coating step, (2) simultaneous diffusion in the vicinity of the interface during progress of the coating step, (3) diffusion with heating during soldering of the contact substrate 10 having the contact surface side metal coated layer 11 to the electrode, (4) diffusion of the both cases of (1) and (2) as mixed together, etc. In the diffusion step, diffusion from the contact substrate 10 to the contact surface metal coated layer 11 is also effected at the same time.

The diffusion depth Xc is required to be at least 20% of the initial thickness Xb of the contact surface side metal coated layer 11. This is because, with less than 20%, the adhesion strength with the contact substrate 10 becomes weaker, whereby the contact surface side metal coated layer 11 is peeled off to give rise to variance in contact resistance value. Also, the thickness Xb-Xc of the metal coated layer remaining at the undiffused portion, namely at the portion near the contact surface, is required to be 10 µm or less, preferably 5 µm or less. This is because, if the residual metal coated layer thickness Xb-Xc exceeds 10 µm, welding resistance becomes to be lowered.

For forming the contact surface side metal coated layer 11 on the above contact substrate 10, it is preferable to use the ion plating method. The electrochemical plating method of the prior art is not desirable, because corrosion with a plating solution occurs on the contact, and the vacuum deposition method is not desirable because of weak adhesion strength. According to the ion plating method, these disadvantages can be sufficiently cancelled, and can provide the highest class of vacuum interrupter contact.

Table 1 shows evaluation of the contact resistance characteristics and welding characteristics of the vacuum interrupter contacts for experiments by use of Cu-50Cr type alloys. In the Table Rc shows contact resistance.

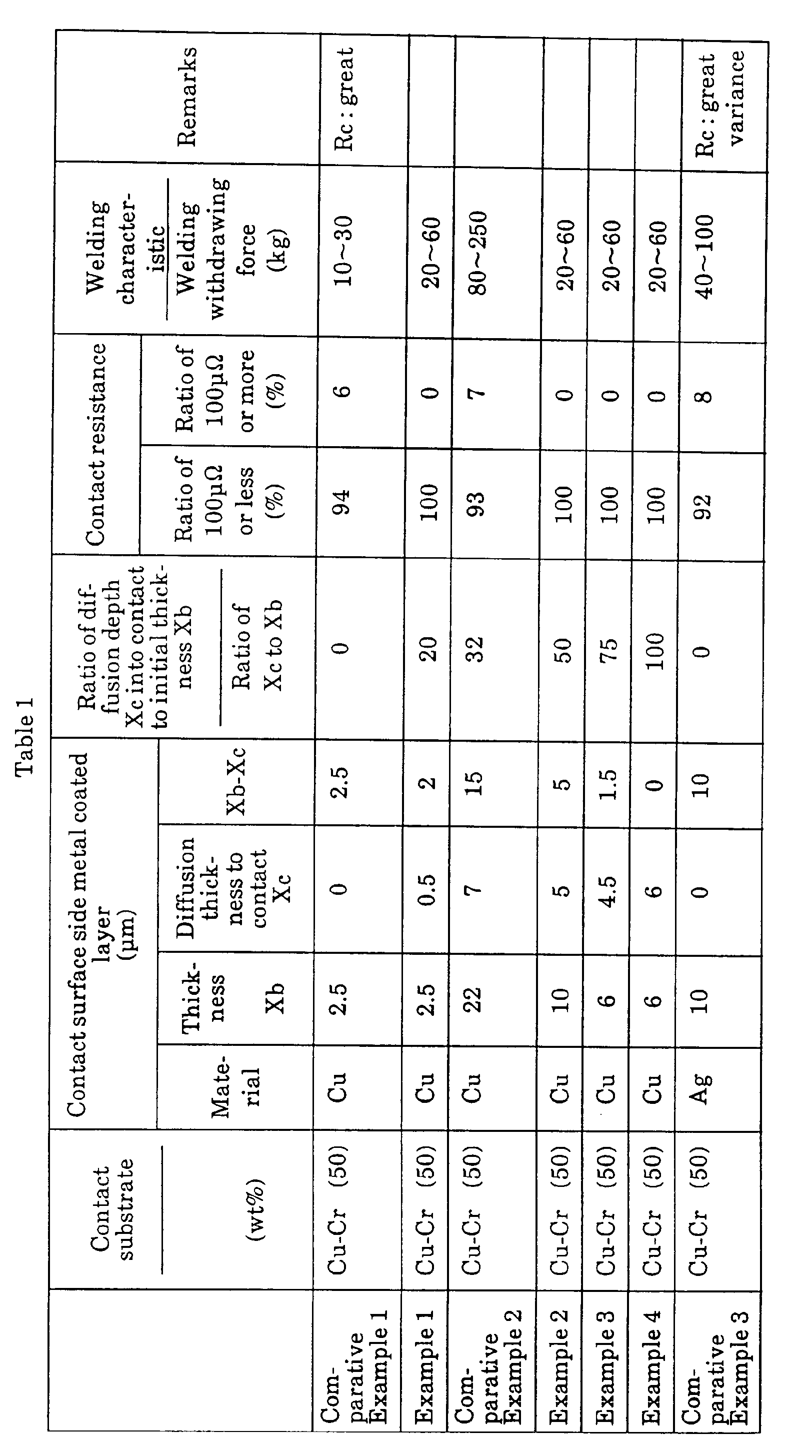

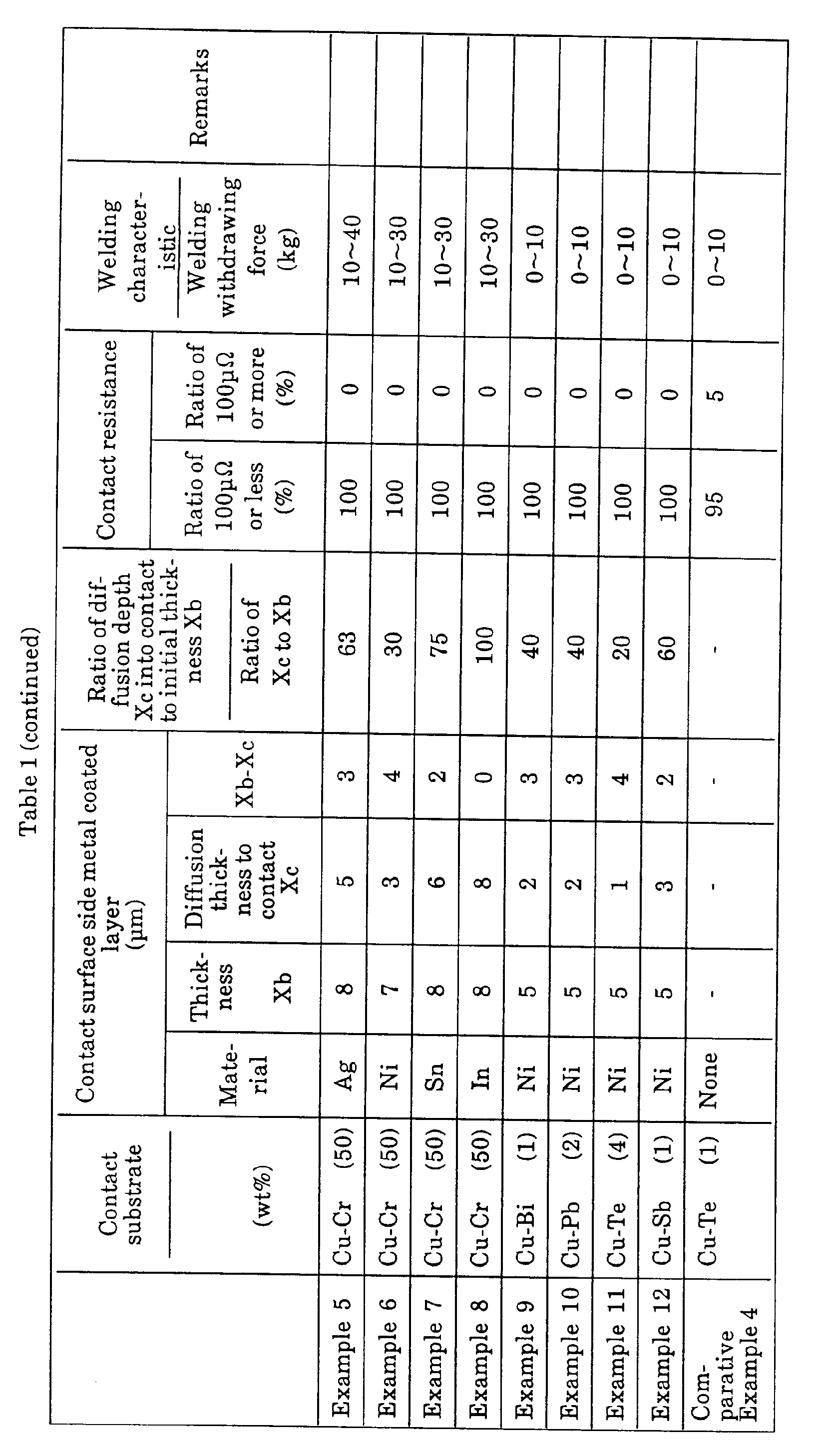

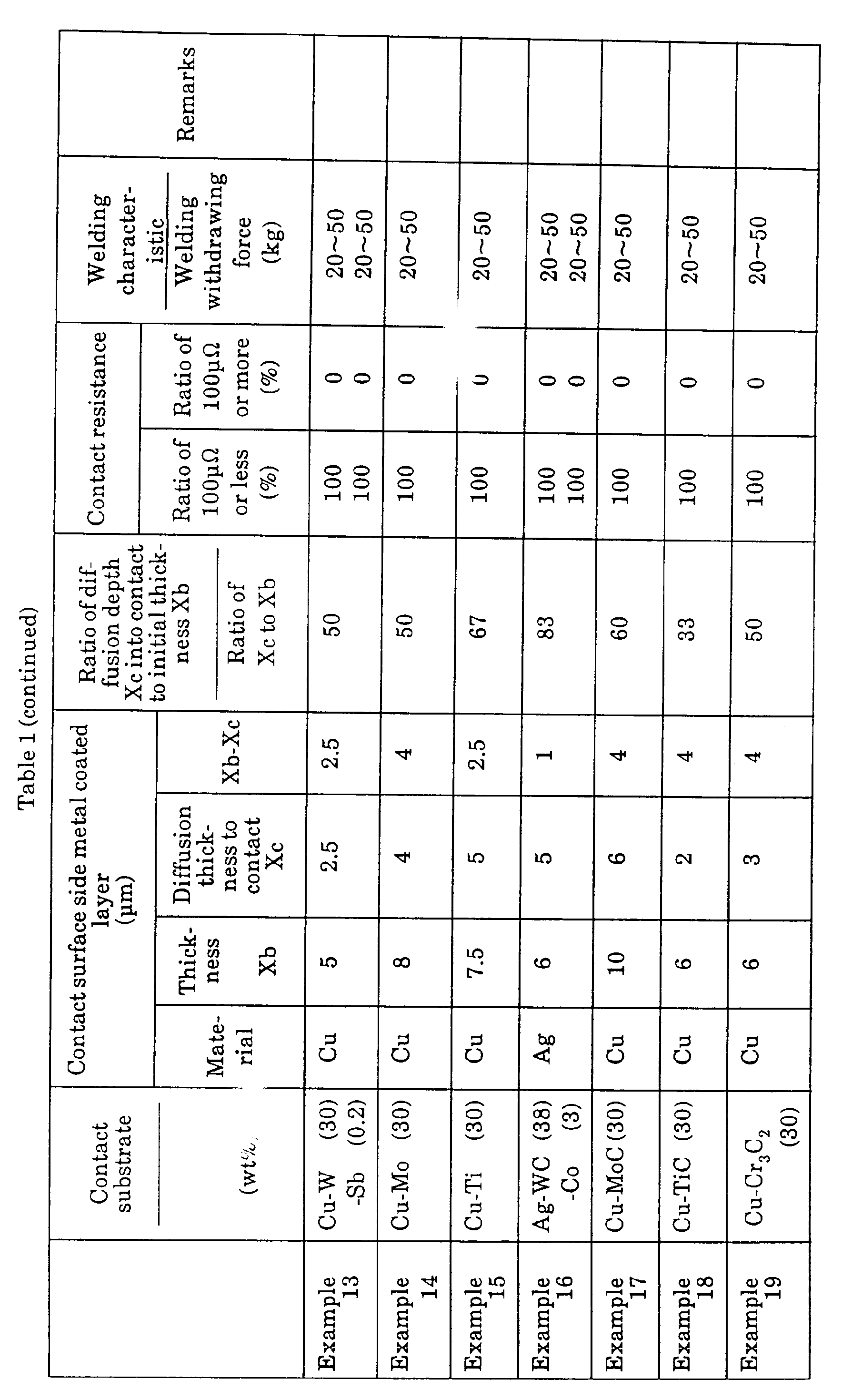

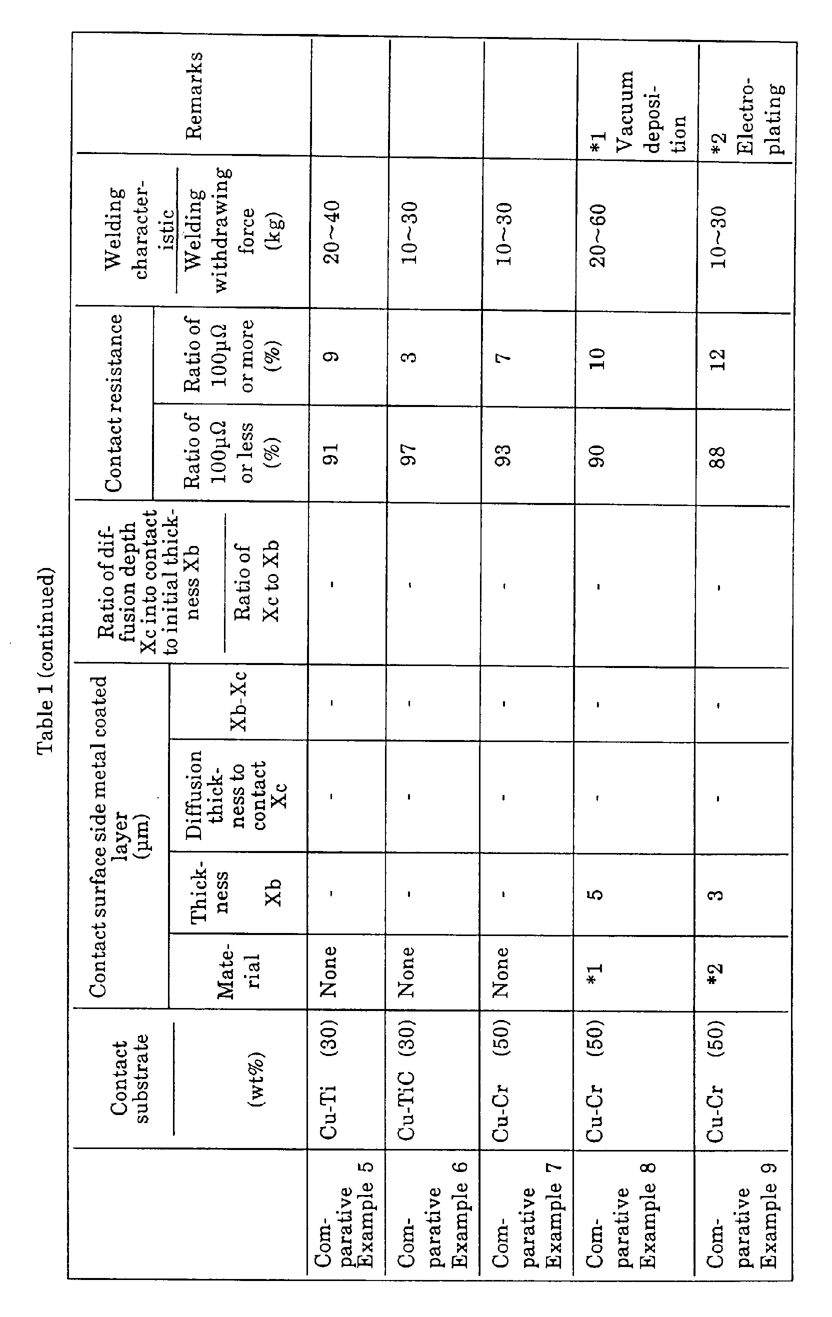

In Table 1, comparison is made between the case where Cu was coated respectively on the contact surface of the contact substrate 10 and the bonded surface on the opposite side by means of an ion plating device (Examples 1 - 4, Comparative Examples 1 - 2),
the case where Ag was coated (Example 5, Comparative Example 3),
the case where Ni was coated (Example 6),
the case where Sn was coated (Example 7),
the case where In was coated (Example 8),
on the contact surface of the contact substrate 10 and the bonded surface on the opposite side by means of an ion plating device, and further
the case where nothing is coated on the contact surface of the contact substrate 10 and the bonded surface on the opposite side (Comparative Example 7).

Here, ion plating is conducted by applying a voltage of 2000 V under a vacuum degree of 4 x 10⁻⁵ mmHg after heating the contact substrate 10 under evacuation of 10⁻⁵ mmHg as the pretreatment. The thickness Xb of the contact surface side metal coating layer 11 is measured by use of other test strips not used for various tests as described above by using a film thickness meter and an ion microanalyzer in combination. Further, the diffusion depth Xc into the contact substrate 10 is measured by microscopic observation of the test strip cross-section and X-ray microanalyzer. Further, diffusion into the contact substrate 10 during ion plating has been known to proceed in the vicinity of the interface, and also in the process of the soldering treatment between the contact and the electrode, and therefore the above diffusion depth Xc is measured after giving the soldering treatment.

The contact applied with the metal coated layer 11 is assembled in an insulating vessel of a vacuum interrupter, and after the insulating vessel is made a vacuum degree of 10⁻⁷ mmHg, it is heated to 600°C to apply the baking treatment, followed further by application of a voltage of about 80 KV to effect the conditioning treatment. The contact resistance and the welding force of the vacuum interrupter contact thus obtained are shown in Table 1.

Here, the contact resistance is measured for 10 vacuum interrupters by passing current of DC 10A after contacting 10 sites for each breaker with the electrode contact under a contact load of 20 kg. The contact resistance is shown in terms of the ratio of the contact resistance value of less than 100 µΩ to that of 100 µΩ. The welding force is measured in terms of the withdrawing force of the contact after welding of the electrode contact under the conditions of a contact load of 50 kg, a current passage of 40 KA and a current passage time of 10 ms.

As is also apparent from Table 1, it can be understood that with a thickness Xb-Xc of the metal coated layer 11 remaining on the contact surface side of the contact of 5 µm or less, e.g., Examples 1 - 4, the contact resistance is stabilized as less than 100 µΩ, but in the case of a thickness of 5 µm or more, e.g., Comparative Example 2, the contact resistance may become 100 µΩ or higher to result in unstable. This is because that cracks or collapses appear on the metal coated layer 11 as the result of impact by opening and closing actuations of the contact, where foreign matters may be progressed or attached, or contact constitutent material elements other than the coated metal may be migrated from the base to the surface, thereby increasing the contact resistance. Even when the thickness Xb-Xc of the remaining metal coated layer 11 may be within a preferable range, if there is no diffusion between the metal coated layer and the contact substrate, and yet there is a problem in strength (e.g. Comparative Example 1), it can be understood that the contact resistance becomes unstable by exposure of the contact substrate due to peel-off or drop-off of the metal coated layer from the contact substrate.

As is apparent from the above descriptions, by making the thickness Xb-Xc of the metal coated layer 11 remaining on the contact surface side of the contact 5 µm or less, and yet the ratio of the diffusion depth Xc to the metal coated layer thickness Xb 20% or higher, a vacuum interrupter having stable contact resistance can be obtained.

This is also the same where the material constitution of the metal coated layer 11 is made of Ag. That is, in the case of a thickness of Xb-Xc of the metal coated layer 11 of 10 µm (e.g. Comparative Example 3), variance is seen unfavorably in contact resistance, but in the case where the thickness Xb-Xc of the metal coated layer 11 is 3 µm and yet the ratio of the diffusion depth Xc to the metal coated layer thickness Xb is 63% (e.g. Example 5), it can be understood that the contact resistance is stable.

Also, it can be understood that the thickness Xb-Xc has also an influence on welding characteristics. For example, when the thickness Xb-Xc is thick as 15 mm (e.g. Comparative Example 2), the welding withdrawing force can be understood to be high and yet large in width of variance. This fact is evident when compared with the case of the Cu-Cr type cpontact without metal coated layer (e.g. Comparative Example 7).

Further, it can be understood that peeling of the metal coated layer 11 can be easily done when the metal coated layer is formed by the vacuum vapor deposition method or the electroplating method (e.g. Comparative Examples 8 - 9). With this fact, superiority of the ion plating method can be understood.

The effect and the tendency as described above are the same even when the contact material may be the Cu-Bi type, and Cu-Pb type, the Cu-Te type, the Cu-Sb type (e.g. Examples 9 - 12), and this fact is evident also when compared with the case of the Cu-Te type without the metal coated layer (e.g. Comparative Exampled 4). Also, the above effect and the above tendency are the same with other contact materials. The Cu-W-Sb type, the Cu-Mo type, the Cu-Ti type, the Ag-WC-Co type, the Cu-MoC type, the Cu-TiC type, the Cu-Cr₃C₂ type (e.g. Examples 13 - 19), and this fact is evident also when compared with the case of the Cu-Ti, Cu-TiC, Cu-Cr type contact without the metal coated layer (e.g. Comparative Examples 5 - 7).

Further, as the material for the contact substrate 10, Cu is not limitative but Ag may be employed. When Ag is used as the material for the contact substrate (e.g. Example 16), the above effect and the above tendency can be also obtained.

Next, the step of forming a metal coated layer on the contact surface side of the contact substrate is to be described. The coating step, as shown in Fig. 3, prepares a contact substrate 10 and forms a bonded surface side metal coating layer 12 on the soldering bonded surface such as electrode according to the ion plating method. Here, as the contact substrate 10, other than the Cu-Cr system, the Cu-Ti system, contact materials including active metals such as Cr, Ti, Al, etc. may be variously employed suitably depending on the purpose. As the bonded surface side metal coated layer 12, at least one metal selected from among Cu, Ag and Ni may be employed.

Also, as shown in Fig. 4, a contact substrate 10 is prepared, and a bonded surface side metal coated layer 12 is formed according to the ion plating method on the soldering bonded surface side such as electrode. Here, as the contact substrate 10, in addition to the contact materials, materials such as the Cu-Bi type, the Cu-Te type, the Cu-W type, the Cu-WC type, the Ag-W type, or the Ag-WC type are used variously suitably corresponding to the purpose. As the barrier layer 13, Fe, Ni or both metals may be employed, and as the bonded surface side metal coated layer, at least one metal selected from among Cu, Ag and Ni may be employed,.

When the contact thus formed is bonded to an electrode by silver soldering, the metal coated layer 12 or the barrier layer 13 is diffused into the contact substrate 10.

For formation of the bonded surface side metal coated layer 12 or the barrier layer 13 on the above contact substrate 10, it is preferable to use the ion plating method. The reason is the same as explained in the case of forming the contact surface side metal coated layer 11.

In Tables 2 - 3, vacuum interrupter contacts for experiments were formed by use of Cu-50Cr, and the results of evaluation of the tensile strength at the silver soldered portion of the contacts are shown.

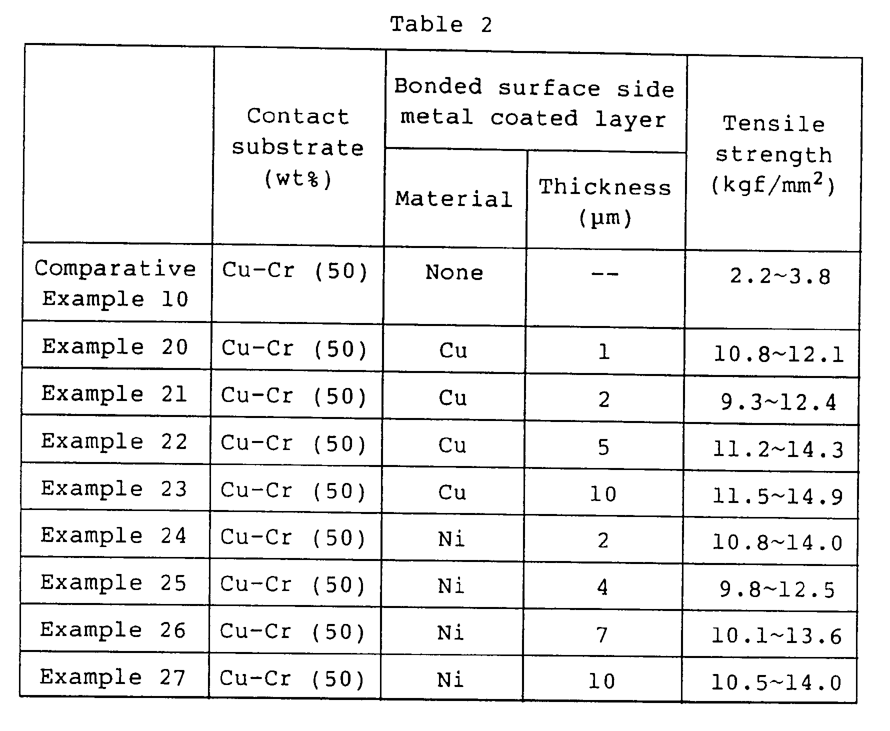

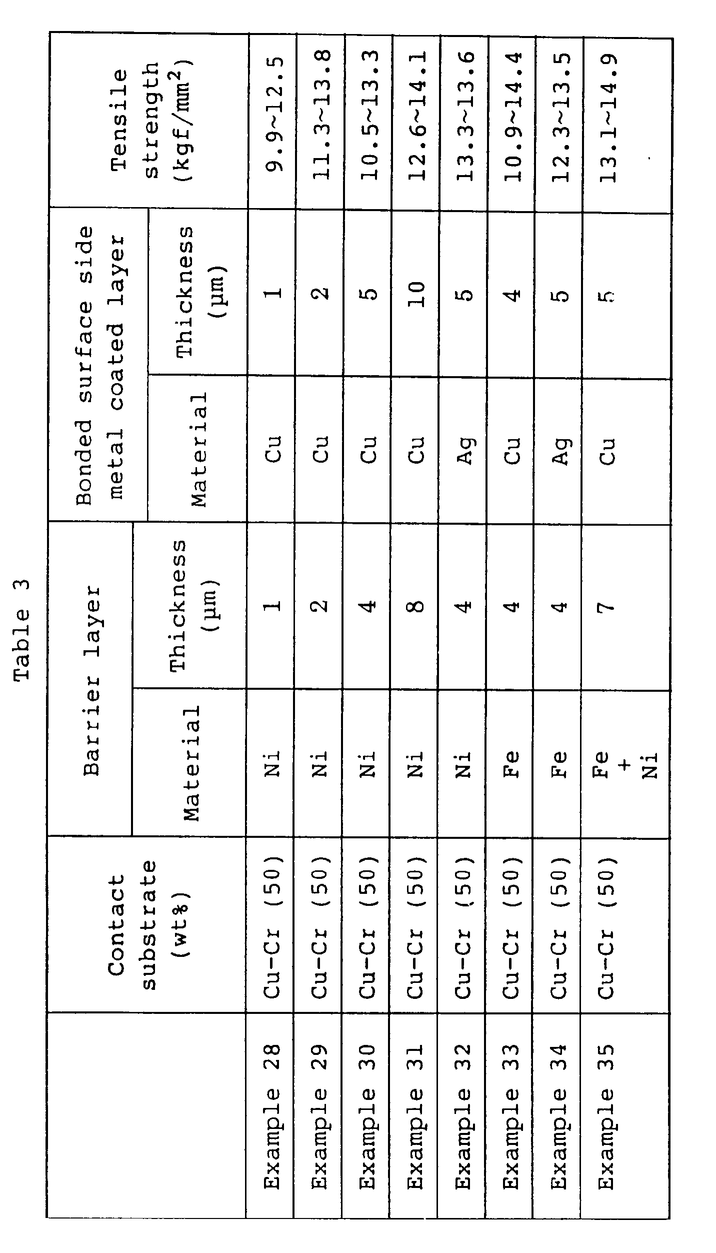

In Tables 2 - 3, comparison is made between the case when Cu was coated on the bonded surface of the contact substrate 10 by means of an ion plating device (Examples 20 - 23),
the case where Ni was coated (Examples 24 - 27),
the case where Ni was coated as the barrier layer 13 (Examples 28 - 32),
the case where Fe was coated,
the case where a mixture of each 50% of Fe and Ni was coated (Example 35),
and further the case where nothing was coated on the bonded surface of the contact substrate 10 (Comparative Example 10).

Here, ion plating is conducted by applying a voltage of 2000 V under a vacuum degree of 4 x 10⁻⁵ mmHg after heating the contact substrate 10 under evacuation of 10⁻⁵ mmHg as the pretreatment. The thicknesses of the bonded surface side metal coated layer 12 and the barrier layer 13 were measured by use of other test strips not used for various tests as described above, using a film thickness meter and an ion microanalyzer in combination, and also measured by microscopic observation of the test strip cross-section and an X-ray microanalyzer. Measurement of the thickness is performed before the silver soldering treatment.

The vacuum interrupter contact thus obtained was solder bonded by use of Cu and Ag based soldering materials for bonding in a hydrogen reducing atmosphere to assemble a test piece for evaluation of tensile strength. Also, for comparison, the contact substrate without the metal coated layer was similarly assembled. The number of samples provided was 20 for each case, and the test pieces were applied to a tensile tester.

As is also apparent from Tables 2 - 3, in absence of the metal coated layer (Comparative Example 10), the tensile strength was found to be 2.2 - 3.8 kg/mm², indicating breaking from the solder bonded portion. In contrast, according to the present Examples 20 - 35, all were found to be broken from the contact substrate portion, and it can be understood that the strength of the solder bonded portion is improved to great extent as compared with the prior art example.

The effect as described above is not limited to the case of the material of the contact substrate of the Cu-Cr type alloy, but the same is the case also with those containing active metals such as Cr, Ti, Al, etc., and the effect will appear conspicuously as its content is larger, for example 20% by weight or more. Even in the case when containing no active metal such as Cr, Ti, Al, etc., when contamination with oxide coating is considered before assembling of the vacuum interrupter, the process of the present invention is effective regardless of the constituent components of the contact substrate.

Also, as shown in Fig. 5, it is possible to form previously Cu or Ag based soldering material 14 for bonding according to the ion plating method on the contact substrate 10 before soldering bonding. As the method for forming the metal coated layer, the barrier layer, the soldering material, etc., corresponding to the bonding strength required, in addition to the ion plating method, other thin film forming techniques can be also practiced in combination.

Further, formation of a large number of suitable coated layers corresponding to the purpose and use is evidently effective, provided that the spirit of the present invention is not altered. Further, with a thickness of the bonded surface side metal coated layer, the barrier layer less than 1 µm has no sufficient effect of preventing the surface oxidation, while a thickness over 10 µm is not industrial because too much time is required for forming the coated layer, even if the effect of the present invention may be obtained.

As described above, according to the present Examples, it is possible to obtain a vacuum interrupter contact of high reliability having no site with such large contact resistance as 100 µΩ, with little variance in contact resistance value, and further with the average value of contact resistance value being suppressed at 50 µΩ or lower. Also, not only improvement of stability of contact resistance but also welding withdrawing force can be maintained small, and further the bonding strength at the soldering bonding portion can be improved.

As can be evidently seen from the above description, according to the present invention, there can be obtained a vacuum interrupter contact of high reliability with little contact resistance, also with little variance in contact resistance value, capable of maintaining the welding withdrawing force small, and yet having great bonding strength at the soldering portion.

## Claims

1. A vacuum breaker contact comprising:
a breaker contact substrate having a predetermined shape; and
a metal coated layer formed on at least a part of the surface of the side of said breaker contact substrate where the opposed breaker contact is in contact thereto, said metal coated layer comprising at least one metal selected from the group consisting of Cu, Ag, Ni, Sn, In, Fe and alloys thereof, said metal coated layer having a thickness of 10 µm or less **characterized** in that
a part of the metal coated layer is diffused into at least a part of said contact substrate.

2. A vacuum breaker contact according to claim 1, wherein said metal coated layer has a thickness of 5 µm or less.

3. A vacuum breaker contact according to claim 1 or 2 wherein the metal coated layer is formed on the surface on the side of said contact substrate to be soldered.

4. A vacuum breaker contact according to one of the preceding claims, wherein said metal coated layer is formed by the ion plating method.

5. A vacuum breaker contact according to one of the preceding claims, wherein the depth of diffusion of said metal coated layer into said contact substrate has reached at least 20% of the thickness of the metal coated layer before diffusion.

6. A vacuum breaker contact according to one of the preceding claims, wherein a barrier layer comprising Fe and/or Ni is formed between said substrate and the metal coated layer.

7. A vacuum breaker contact according to one of the preceding claims, wherein metal coated layers are formed on both of the surface on the side where the opposed contact of said contact substrate is in contact and the surface on the side to be soldered.

8. A vacuum breaker contact according to claim 1, wherein said contact substrate comprises an alloy containing 20 to 80% by weight of at least one of Al, Ti and Cr with the balance comprising Cu and/or Ag.

9. A vacuum breaker equipped with the contact according to claim 1.

10. A method for producing a vacuum breaker contact comprising:
a coating step for forming a metal coated layer on at least a part of the surface of a breaker contact substrate having a predetermined shape to a thickness of 10 µm or less;
said metal coated layer comprising at least one metal selected from the group consisting of Cu, Ag, Ni, Sn, In, Fe and alloys thereof;
**characterized** by
a diffusion step for diffusing a part of the metal coated layer into at least a part of said contact substrate.

11. A method according to claim 10, wherein in the diffusion step the depth of diffusion of said metal coated layer into said contact substrate reaches at least 20% of the thickness of the metal coated layer before diffusion.

12. A process according to claim 10 or 11, wherein said diffusion step is carried out so that the thickness of the metal coated layer at the undiffused portion existing on the surface of said contact substrate may be within the range of from 0 to 5 µm.

13. A process according to claim 10, 11 or 12, wherein said coating step is practiced according to the ion plating method.

14. A process according to one of claims 10 to 13, wherein said diffusion step is carried out by heating at a temperature of at least 400°C.

15. A process according to one of claims 10 to 14, comprising the step of forming a barrier layer comprising Fe and/or Ni on the surface of said substrate prior to said coating step.

16. A process according to one of claims 10 to 15, comprising further the step of applying the conditioning treatment on the surface of said metal coated layer.

17. A process according to one of claims 10 to 16, wherein heating in said diffusion step is carried out simultaneously during heating for soldering for the contact.

18. A process according to claim 15, comprising the step of bonding Cu and/or Ag based soldering material on the surface of said metal coated layer.

19. A process according to claim 18, wherein the layer of said soldering material is formed according to the ion plating method.

20. A process according to one of claims 10 to 19, wherein said contact substrate comprises an alloy containing 20 to 80% by weight of at least one kind of Al, Ti and Cr with the balance comprising Cu and/or Ag.

## Patentansprüche

1. Vakuumschalterkontakt, welcher umfaßt:
- ein Schalterkontaktsubstrat mit einer vorbestimmten Form und
- eine metallische Beschichtungsschicht, welche zumindest auf einem Teil der Oberfläche der Seite des Schalterkontaktsubstrats ausgebildet ist, wo der gegenüberliegende Schalterkontakt in Kontakt damit ist,
wobei die metallische Beschichtungsschicht zumindest ein Metall umfaßt, welches aus der Gruppe gewählt ist, welche aus Cu, Ag, Ni, Sn, In, Fe und Legierungen hiervon besteht, und diese metallische Beschichtungsschicht eine Dicke von 10µm oder weniger aufweist,
dadurch gekennzeichnet,
daß ein Teil der metallischen Beschichtungsschicht zumindest in einen Teil des Kontaktsubstrats diffundiert ist.

2. Vakuumschalterkontakt nach Anspruch 1, bei dem die metallische Beschichtungsschicht eine Dicke von 5µm oder weniger aufweist.

3. Vakuumschalterkontakt nach Anspruch 1 oder 2, bei dem die metallische Beschichtungsschicht auf der Oberfläche der zu verlötenden Seite des Kontaktsubstrats ausgebildet ist.

4. Vakuumschalterkontakt nach einem der vorangehenden Ansprüche, bei dem die metallische Beschichtungsschicht durch das Ionenplattierungsverfahren ausgebildet ist.

5. Vakuumschalterkontakt nach einem der vorangehenden Ansprüche, bei dem die Tiefe der Diffusion der metallischen Beschichtungsschicht in das Kontaktsubstrat mindestens 20% der Dicke der metallischen Beschichtungsschicht vor der Diffusion erreicht hat.

6. Vakuumschalterkontakt nach einem der vorangehenden Ansprüche, bei dem eine Barrierenschicht, welche Fe und/oder Ni umfaßt, zwischen dem Substrat und der metallischen Beschichtungsschicht ausgebildet ist.

7. Vakuumschalterkontakt nach einem der vorangehenden Ansprüche, bei dem metallische Beschichtungsschichten sowohl auf der Oberfläche auf der Seite, wo der gegenüberliegende Kontakt des Kontaktsubstrats in Kontakt ist, als auch auf der Oberfläche auf der zu verlötenden Seite ausgebildet sind.

8. Vakuumschalterkontakt nach Anspruch 1, bei dem das Kontaktsubstrat eine Legierung umfaßt, welche 20 Gew.-% bis 80 Gew.-% zumindest eines Materials aus Al, Ti und Cr umfaßt, wobei der Rest Cu und/oder Ag umfaßt.

9. Vakuumschalter, welcher mit dem Kontakt nach Anspruch 1 ausgerüstet ist.

10. Verfahren zum Herstellen eines Vakuumschalterkontakts, welches einen Beschichtungsschritt zum Ausbilden einer metallischen Beschichtungsschicht zumindest auf einem Teil der Oberfläche eines Schalterkontaktsubstrats mit einer vorbestimmten Form bis zu einer Dicke von 10µm oder weniger umfaßt, wobei die metallische Beschichtungsschicht zumindest ein Metall umfaßt, das aus der Gruppe gewählt ist, welche aus Cu, Ag, Ni, Sn, In, Fe und Legierungen hiervon besteht,
gekennzeichnet durch einen Diffusionsschritt zum Diffundieren eines Teils der metallischen Beschichtungsschicht zumindest in einen Teil des Kontaktsubstrats.

11. Verfahren nach Anspruch 10, bei dem in dem Diffusionsschritt die Tiefe der Diffusion der metallischen Beschichtungsschicht in das Kontaktsubstrat zumindest 20% der Dicke der metallischen Beschichtungsschicht vor der Diffusion erreicht.

12. Prozeß nach Anspruch 10 oder 11, bei dem der Diffusionsschritt so ausgeführt wird, daß die Dicke der metallischen Beschichtungsschicht in dem nicht diffundierten Abschnitt, welcher an der Oberfläche des Kontaktsubstrats vorhanden ist, in dem Bereich von 0µm bis 5µm liegen kann.

13. Prozeß nach Anspruch 10, 11 oder 12, bei dem der Beschichtungsschritt gemäß dem Ionenplattierungsverfahren ausgeführt wird.

14. Prozeß nach einem der Ansprüche 10 bis 13, bei dem der Diffusionsschritt durch Heizen bei einer Temperatur von mindestens 400°C ausgeführt wird.

15. Prozeß nach einem der Ansprüche 10 bis 14, welcher den Schritt des Ausbildens einer Fe und/oder Ni enthaltenden Barrierenschicht auf der Oberfläche des Substrats vor dem Beschichtungsschritt umfaßt.

16. Prozeß nach einem der Ansprüche 10 bis 15, welcher weiterhin den Schritt des Unterziehens der Oberfläche der metallischen Beschichtungsschicht unter eine Konditionierbehandlung umfaßt.

17. Prozeß nach einem der Ansprüche 10 bis 16, bei dem das Heizen in dem Diffusionsschritt gleichzeitig mit dem Heizen zum Verlöten des Kontakts ausgeführt wird.

18. Prozeß nach Anspruch 15, welcher den Schritt des Verbindens eines Lötmaterials auf Cu- und/oder Ag-Basis mit der Oberfläche der metallischen Beschichtungsschicht umfaßt.

19. Prozeß nach Anspruch 18, bei dem die Schicht des Lötmaterials nach dem Ionenplattierungsverfahren ausgebildet wird.

20. Prozeß nach einem der Ansprüche 10 bis 19, bei dem das Kontaktsubstrat eine Legierung umfaßt, welche 20 Gew.-% bis 80 Gew.-% von mindestens einer Sorte aus Al, Ti und Cr enthält, wobei der Rest Cu und/oder Ag umfaßt.

## Revendications

1. Contact d'interrupteur à vide comportant:
un substrat de contact d'interrupteur ayant une forme prédéterminée; et
une couche de recouvrement métallique formée sur au moins une partie de la surface du côté dudit substrat de contact d'interrupteur où le contact d'interrupteur opposé est en contact avec celle-ci, ladite couche de recouvrement métallique comportant au moins un métal choisi dans le groupe constitué de Cu, Ag, Ni, Sn, In, Fe et les alliages de ceux-ci, ladite couche de recouvrement métallique ayant une épaisseur de 10 µm ou moins, caractérisé en ce que
une partie de la couche de recouvrement métallique est diffusée dans au moins une partie dudit substrat de contact.

2. Contact d'interrupteur à vide selon la revendication 1, dans lequel ladite couche de recouvrement métallique a une épaisseur de 5 µm ou moins.

3. Contact d'interrupteur à vide selon la revendication 1 ou 2, dans lequel la couche de recouvrement métallique est formée sur la surface située du côté dudit substrat de contact à souder.

4. Contact d'interrupteur à vide selon l'une des revendications précédentes, dans lequel ladite couche de recouvrement métallique est formée par le procédé de dépôt ionique.

5. Contact d'interrupteur à vide selon l'une des revendications précédentes, dans lequel la profondeur de diffusion de ladite couche de recouvrement métallique dans ledit substrat de contact atteint au moins 20% de l'épaisseur de la couche de recouvrement métallique avant diffusion.

6. Contact d'interrupteur à vide selon l'une des revendications précédentes, dans lequel une couche d'arrêt comportant Fe et/ou Ni est formée entre ledit substrat et la couche de recouvrement métallique.

7. Contact d'interrupteur à vide selon l'une des revendications précédentes, dans lequel des couches de recouvrements métalliques sont formées à la fois sur la surface située du côté où le contact opposé audit substrat de contact est en contact et sur la surface du côté à souder.

8. Contact d'interrupteur à vide selon la revendication 1, dans lequel ledit substrat de contact comporte un alliage contenant de 20 à 80% en poids d'au moins l'un des Al, Ti et Cr, l'équilibre comportant Cu et/ou Ag.

9. Interrupteur à vide équipé du contact selon la revendication 1.

10. Procédé pour produire un contact d'interrupteur à vide comportant:
une étape de dépôt pour former une couche de recouvrement métallique sur au moins une partie de la surface d'un substrat de contact d'interrupteur ayant une forme prédéterminée jusqu'à une épaisseur de 10 µm ou moins;
ladite couche de recouvrement métallique comportant au moins un métal choisi dans le groupe constitué de Cu, Ag, Ni, Sn, In, Fe et les alliages de ceux-ci;
caractérisé par
une étape de diffusion pour diffuser une partie de la couche de recouvrement métallique dans au moins une partie dudit substrat de contact.

11. Procédé selon la revendication 10, dans lequel, dans l'étape de diffusion, la profondeur de diffusion de ladite couche de recouvrement métallique dans ledit substrat de contact, atteint au moins 20% de l'épaisseur de la couche de recouvrement métallique avant diffusion.

12. Procédé selon la revendication 10 ou 11, dans lequel ladite étape de diffusion est effectuée de façon que l'épaisseur de la couche de recouvrement métallique située sur la partie non-diffusée qui existe sur la surface dudit substrat de contact se trouve à l'intérieur de la plage de 0 à 5 µm.

13. Procédé selon la revendication 10, 11 ou 12, dans lequel ladite étape de dépôt est exécutée selon le procédé de dépôt ionique.

14. Procédé selon l'une des revendications 10 à 13, dans lequel ladite étape de diffusion est exécutée par chauffage à une température de 400°C au moins.

15. Procédé selon l'une des revendications 10 à 14, comportant l'étape de formation d'une couche d'arrêt comportant Fe et/ou Ni, sur la surface dudit substrat avant ladite étape de dépôt.

16. Procédé selon l'une des revendications 10 à 15, comportant en outre l'étape d'application du traitement de conditionnement sur la surface de ladite couche de recouvrement métallique.

17. Procédé selon l'une des revendications 10 à 16, dans lequel le chauffage dans ladite étape de diffusion est effectué simultanément avec le chauffage pour le soudage destiné au contact.

18. Procédé selon la revendication 15, comportant l'étape de collage de la matière de soudage à base de Cu et/ou d'Ag, sur la surface de ladite couche de recouvrement métallique.

19. Procédé selon la revendication 18, dans lequel la couche de ladite matière de soudage est formée par le procédé de dépôt ionique.

20. Procédé selon l'une des revendications 10 à 19, dans lequel ledit substrat de contact comporte un alliage contenant de 20 à 80% en poids d'au moins une sorte des Al, Ti et Cr, l'équilibre comportant Cu et/ou Ag.
